(19) Europäisches Patentamt
European Patent Office
Office européen des brevets

(11) **EP 4 685 502 A1**

(12) **EUROPEAN PATENT APPLICATION**
published in accordance with Art. 153(4) EPC

(43) Date of publication:
**28.01.2026 Bulletin 2026/05**

(21) Application number: **24811298.9**

(22) Date of filing: **30.04.2024**

(51) International Patent Classification (IPC):
*G01R 31/327* (2006.01)   *G01R 31/52* (2020.01)
*G01R 31/56* (2020.01)   *G01R 27/02* (2006.01)
*G01R 19/00* (2006.01)   *G01R 19/10* (2006.01)
*G01R 19/165* (2006.01)

(52) Cooperative Patent Classification (CPC):
Y02E 60/10

(86) International application number:
**PCT/KR2024/005863**

(87) International publication number:
**WO 2024/242359 (28.11.2024 Gazette 2024/48)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **22.05.2023 KR 20230065485**

(71) Applicant: **LG Energy Solution, Ltd.
Seoul 07335 (KR)**

(72) Inventor: **KIM, Hansol
Daejeon 34122 (KR)**

(74) Representative: **Plasseraud IP
104 Rue de Richelieu
CS92104
75080 Paris Cedex 02 (FR)**

(54) **RELAY DIAGNOSIS CIRCUIT AND BATTERY DEVICE COMPRISING SAME**

(57)   A relay diagnostic circuit for performing diagnosis on a positive main relay and a negative main relay that control a connection between a battery pack and an external electrical device includes: a detection voltage source; a first resistor and a second resistor connected in series between a first connection terminal and a second connection terminal; a third resistor and a fourth resistor connected in series between a first node to which the first resistor and the second resistor are connected and a negative electrode of the battery pack; a fifth resistor and a sixth resistor connected in series between a second node to which the third resistor and the fourth resistor are connected and the negative electrode of the battery pack; a connection switch connected between the detection voltage source and a third node; a seventh resistor connected between the third node and the first node; an eighth resistor and a ninth resistor connected in series between the third node and the negative electrode of the battery pack; and a tenth resistor and an eleventh resistor R21 and R22 connected in series between a fourth node N4 to which the eighth resistor and the ninth resistor are connected and the negative electrode of the battery pack.

[Figure 1]

**Description**

**[Technical Field]**

CROSS-REFERENCE TO RELATED APPLICATION(S)

This application claims priority to and the benefit of Korean Patent Application No. 10-2023-0065485 filed in the Korean Intellectual Property Office on May 22, 2023, the entire contents of which are incorporated herein by reference.

The present disclosure relates to a relay diagnostic circuit and a battery device including the same.

**[Background Art]**

A main relay is connected between a battery device and external electrical devices such as an electric load and a charger. For example, a positive main relay is connected between a positive electrode of a battery device and a positive electrode of an external electrical device, and a negative main relay is connected between a negative electrode of the battery device and a negative electrode of the external electrical device.

At least one of the two main relays may become stuck closed. The battery device and the external electrical device may be short-circuited by the stuck closed main relay. The short circuit between the battery device and the external electrical device may cause the battery device to discharge, reducing the lifespan of the battery device and causing safety problems such as an increase in temperature.

**[Disclosure]**

**[Technical Problem]**

The present disclosure attempts to provide a relay diagnostic circuit capable of performing a stuck closed diagnosis for two main relays connected to each battery pack in a battery device including a plurality of battery packs, and a battery device including the same.

**[Technical Solution]**

According to an exemplary embodiment of the present disclosure, a relay diagnostic circuit for performing diagnosis on a positive main relay and a negative main relay that control a connection between a battery pack and an external electrical device includes: a detection voltage source; a first resistor and a second resistor connected in series between a first connection terminal and a second connection terminal; a third resistor and a fourth resistor connected in series between a first node to which the first resistor and the second resistor are connected and a negative electrode of the battery pack; a fifth resistor and a sixth resistor connected in series between a second node to which the third resistor and the fourth resistor are connected and the negative electrode of the battery pack; a connection switch connected between the detection voltage source and a third node; a seventh resistor connected between the third node and the first node; an eighth resistor and a ninth resistor connected in series between the third node and the negative electrode of the battery pack; and a tenth resistor and an eleventh resistor connected in series between a fourth node to which the eighth resistor and the ninth resistor are connected and the negative electrode of the battery pack.

The relay diagnostic circuit may turn on the connection switch during a predetermined diagnosis period, and provide a first detection voltage that is a voltage of a first detection node to which the fifth resistor and the sixth resistor are connected and a second detection voltage that is a voltage of a second detection node to which the tenth resistor and the eleventh resistor are connected.

According to another exemplary embodiment of the present disclosure, a battery device includes: a battery pack; and a battery disconnect unit including a positive main relay connected between a positive electrode of the battery pack and a first connection terminal, and a negative main relay connected between a negative electrode of the battery pack and a second connection terminal. The battery disconnect unit may include: a first resistor and a second resistor connected in series between the first connection terminal and the second connection terminal; a third resistor and a fourth resistor connected in series between a first node to which the first resistor and the second resistor are connected and a negative electrode of the battery pack; and a fifth resistor and a sixth resistor connected in series between a second node to which the third resistor and the fourth resistor are connected and the negative electrode of the battery pack. The battery device may measure a first detection voltage that is a voltage of a first detection node to which the fifth and sixth resistors are connected during a predetermined diagnostic period during which the battery pack is not connected to an external electrical device, and perform a stuck closed diagnosis for the positive main relay and the negative main relay according to the first detection voltage.

The battery disconnect unit may further include: a detection voltage source; a connection switch connected between the detection voltage source and a third node and turned on during the diagnosis period; a seventh resistor connected between the third node and the first node; an eighth resistor and a ninth resistor connected in series between the third node and the negative electrode of the battery pack; and a tenth resistor and an eleventh resistor connected in series between a fourth node to which the eighth resistor and the ninth resistor are connected and the negative electrode of the battery pack. The battery device may measure a second detection voltage that is a voltage of a second detection node to which the tenth resistor and the eleventh resistor are connected during the diagnosis period and perform the stuck closed diagnosis for the positive main relay and the negative main relay according to a difference between the first detection voltage and the second detection voltage.

The battery device may further include a main control unit turning off the positive main relay and the negative main relay and turning on the connection switch during the diagnosis period, measuring the first detection voltage and the second detection voltage, and performing the stuck closed diagnosis for the positive main relay and the negative main relay according to a first voltage that is the difference between the first detection voltage and the second detection voltage.

The main control unit may determine that the positive main relay and the negative main relay are in a normal state when the first voltage falls within a predetermined normal range, and determine that at least one of the positive main relay and the negative main relay is stuck closed when the first voltage is outside the normal range.

The predetermined normal range may be determined according to a difference between the first detection voltage determined by resistance-dividing the voltage of the detection voltage source by the seventh resistor, the third resistor, the fourth resistor, the fifth resistor, and the sixth resistor, and the second detection voltage determined by resistance-dividing the voltage of the detection voltage source by the eighth resistor, the ninth resistor, the tenth resistor, and the eleventh resistor.

The main control unit may determine that both the positive main relay and the negative main relay are stuck closed or that the positive main relay is stuck closed when the first voltage is higher than an upper limit of the normal range.

The main control unit may determine that the negative main relay is stuck closed when the first voltage is lower than a lower bound of the normal range.

In the relay diagnostic device and the battery device, when the positive main relay and the negative main relay are stuck closed, during the diagnosis period, the positive electrode of the battery pack may be connected to the first resistor, and the negative electrode of the battery pack may be connected to the second resistor. The voltage applied to the first detection node by resistance-dividing the voltage of the battery pack by the first resistor, the second resistor, the third resistor, the fourth resistor, the fifth resistor, and the sixth resistor and the voltage applied to the second detection node by resistance-dividing the voltage of the detection voltage source by the seventh resistor, the second resistor, the third resistor, the fourth resistor, the fifth resistor, and the sixth resistor may be added to determine the first detection voltage.

In the relay diagnostic device and the battery device, when the positive main relay is stuck closed, during the diagnosis period, the positive electrode of the battery pack may be connected to the first resistor. The voltage applied to the first detection node by resistance-dividing the voltage of the battery pack by the first resistor, the third resistor, the fourth resistor, the fifth resistor, and the sixth resistor and the voltage applied to the second detection node by resistance-dividing the voltage of the detection voltage source by the seventh resistor, the third resistor, the fourth resistor, the fifth resistor, and the sixth resistor may be added to determine the first detection voltage.

In the relay diagnostic device and the battery device, when the negative main relay is stuck closed, during the diagnosis period, the negative electrode of the battery pack may be connected to the second resistor. The first detection voltage may be determined by resistance-dividing the voltage of the detection voltage source by the seventh resistor, the second resistor, the third resistor, the fourth resistor, the fifth resistor, and the sixth resistor.

In the relay diagnostic device and the battery device, when the positive and negative main relay and the negative main relay are in a normal state, during the diagnosis period, the first detection voltage may be determined by resistance-dividing the voltage of the detection voltage source by the seventh resistor, the third resistor, the fourth resistor, the fifth resistor, and the sixth resistor, and the second detection voltage may be determined by resistance-dividing the voltage of the detection voltage source by the eighth resistor, the ninth resistor, the tenth resistor, and the eleventh resistor.

**[Advantageous Effects]**

An aspect of the present disclosure provides a relay diagnostic circuit capable of performing a stuck closed diagnosis for two main relays connected to each battery pack in a battery device including a plurality of battery packs, and a battery device including the same.

**[Description of the Drawings]**

FIG. 1 is a block diagram illustrating a battery device according to an exemplary embodiment.

FIG. 2 is a diagram illustrating a diagnosis period during which stuck closed diagnosis is performed according to an exemplary embodiment.

FIG. 3 is an equivalent circuit illustrating a relay diagnostic circuit when a positive main relay and a negative main relay are in a normally opened state.

FIG. 4 is an equivalent circuit illustrating a relay diagnostic circuit when the positive and negative main relays are in a stuck closed state.

FIG. 5 is an equivalent circuit illustrating the relay diagnostic circuit when the positive main relay is in the stuck closed state.

FIG. 6 is an equivalent circuit illustrating the relay diagnostic circuit when the negative main relay is in the stuck closed state.

**[Mode for Invention]**

When it is decided that a detailed description for the known art related to the present disclosure may obscure the gist of the present disclosure, the detailed description will be omitted. Further, it should be understood that the accompanying drawings are provided only in order to allow exemplary embodiments of the present disclosure to be easily understood, and the spirit of the present disclosure is not limited by the accompanying drawings, but includes all the modifications, equivalents, and substitutions included in the spirit and the scope of the present disclosure.

Terms including an ordinal number such as first, second, etc., may be used to describe various components, but the components are not limited to these terms. The above terms are used solely for the purpose of distinguishing one component from another.

In the present specification, it is to be understood that when one component is referred to as being "connected to" or "coupled to" another component, it may be connected or coupled directly to another component or be connected to another component with the other component interposed therebetween. On the other hand, it should be understood that when one element is referred to as being "connected directly to" or "coupled directly to" another element, it may be connected to or coupled to another element without the other element interposed therebetween.

It will be further understood that terms "include" or "have" used in the present specification specify the presence of features, numerals, steps, operations, components, parts mentioned in the present specification, or combinations thereof, but do not preclude the presence or addition of one or more other features, numerals, steps, operations, components, parts, or combinations thereof.

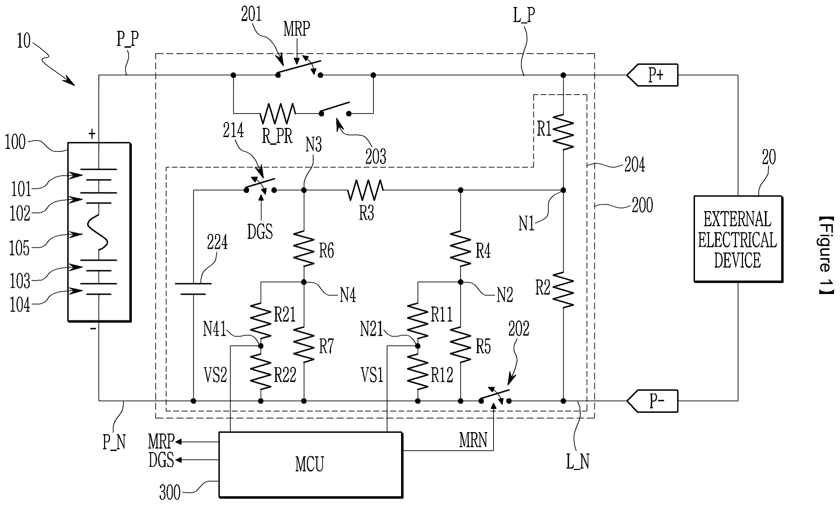

FIG. 1 is a block diagram illustrating a battery device according to an exemplary embodiment.

As illustrated in FIG. 1, a battery device 10 may include a battery pack 100, a battery disconnect unit (BDU) 200, and a main control unit (MCU) 300. The battery disconnect unit 200 and the main control unit 300 may constitute a battery management system (BMS).

The battery pack 100 may be connected to an external electrical device 20 through the battery disconnect unit 200. When the battery device 10 is mounted on a vehicle, the external electrical device 20 may include an inverter that supplies power to an electrical load of a vehicle, a charger provided in the vehicle, etc.

The battery pack 100 may include a plurality of battery cells 101 to 104 and a main fuse 105. In FIG. 1, an example of the battery pack 100 is illustrated as including four battery cells 101 to 104 connected in series. This is an example for describing an exemplary embodiment, and a plurality of battery cells may be connected in series, in parallel, or in series/parallel to constitute the battery pack 100. The main fuse 105 is connected between the battery cell 102 and the battery cell 103. A connection position of the main fuse 105 illustrated in FIG. 1 is an example for describing an exemplary embodiment, and the main fuse 105 may be connected between two adjacent battery cells among the battery cells 101 to 104 or between the battery pack 100 and a main relay 201 or 202. The battery disconnect unit 200 is connected between a positive electrode of the battery pack 100 and a P+ terminal and between a negative electrode of the battery pack 100 and a P- terminal. The 'P+ terminal' may be one of the external connection terminals of the battery device 10, and the 'P- terminal' may be the other of the external connection terminals of the battery device 10.

The battery disconnect unit 200 may include a positive main relay 201, a negative main relay 202, a precharge relay 203, a precharge resistor R_PR, and a relay diagnostic circuit 204.

The positive main relay 201 is connected between the positive electrode of the battery pack 100 and the P+ terminal. The positive main relay 201 may be opened or closed according to a main relay signal MRP provided from the main control unit 300. The negative main relay 202 is connected between the negative electrode and the P- terminal of the battery pack 100. The negative main relay 202 may be opened or closed according to a main relay signal MRN provided from the main control unit 300. The external electrical device 20 may be connected between the P+ and P- terminals of the battery device 10. The precharge relay 203 and the precharge resistor R_PR are connected between the positive electrode of the battery pack 100 and the P+ terminal of the battery device 10. When the battery pack 100 is charged or discharged, the positive main relay 201 and negative main relay 202 are in a closed state. The precharge relay 203 may be first closed before the positive main relay 201 is closed to provide a precharge path, and may be opened after the positive main relay 201 is closed. It is possible to prevent an inrush current that may occur when the battery pack 100 and the external electrical device 20 are connected through the precharge path.

In this specification, a wiring between the positive electrode of the battery pack 100 and the positive main relay 201 is called a battery positive node P_P, a wiring between the positive main relay 201 and the external electrical device 20 is called a link positive node L_P, a wiring between the negative electrode of the battery pack 100 and the negative main relay 202 is called a battery negative node P_N, and a wiring between the negative main relay 202 and the external electrical device 20 is called a link negative node L_N.

The relay diagnostic circuit 204 may provide a first detection voltage VS1 and a second detection voltage VS2 to the main control unit 300 to detect whether the positive main relay 201 and the negative main relay 202 are stuck closed.

The relay diagnostic circuit 204 may include a plurality of resistors R1 to R7, R11, R12, R21, and R22 for generating a first detection voltage VS1 and a second detection voltage VS2, a connection switch 214, and a detection voltage source 225.

One end of the resistor R1 is connected to the link positive node L_P, the other end of the resistor R1 and one end of the resistor R2 are connected to a node N1, and the other end of the resistor R2 is connected to the link negative node L_N. A voltage difference between the link positive node L_P and the link negative node L_N is resistance-divided by the two resistors R1 and R2, and the resistance-divided voltage is a voltage of the node N1.

One end of the resistor R4 is connected to the node N1, the other end of the resistor R4 and one end of the resistor R5 are connected to a node N2, and the other end of the resistor R4 is connected to the link negative node L_N. A voltage difference between the node N1 and the battery negative node P_N is resistance-divided by the two resistors R4 and R5, and the resistance-divided voltage is a voltage of the node N2. One end of the resistor R11 is connected to the node N2, the other end of the resistor R11 and one end of the resistor R12 are connected to a detection node N21, and the other end of the resistor R12 is connected to the battery negative node P_N. A voltage difference between the node N2 and the battery negative node P_N is resistance-divided by the two resistors R11 and R12, and the resistance-divided voltage is a voltage of the detection node N21, that is, the first detection voltage VS1.

The resistor R3 is connected between the node N1 and the node N3.

One end of the resistor R6 is connected to the node N3, the other end of the resistor R6 and one end of the resistor R7 are connected to a node N4, and the other end of the resistor R7 is connected to the battery negative node P_N. A voltage difference between the node N3 and the battery negative node P_N is resistance-divided by the two resistors R6 and R7, and the resistance-divided voltage is a voltage of the node N4. One end of the resistor R21 is connected to the node N4, the other end of the resistor R21 and one end of the resistor R22 are connected to a detection node N41, and the other end of the resistor R22 is connected to the battery negative node P_N. A voltage difference between the node N4 and the battery negative node P_N is resistance-divided by the two resistors R21 and R22, and the resistance-divided voltage is a voltage of the detection node N41, that is, the second detection voltage VS2.

One end of the connection switch 214 is connected to the node N3, the other end of the connection switch 214 is connected to a positive electrode of the detection voltage source 224. A negative electrode of the detection voltage source 224 is connected to the battery negative node P_N. The detection voltage source 224 may supply a predetermined level of voltage based on the battery negative node P_N. A switching operation of the connection switch 214 may be controlled by the main control unit 300. For example, the connection switch 214 may be turned on or off according to a diagnostic switching signal DGS provided from the main control unit 300. In order to perform the stuck closed diagnosis for the main relays 201 and 202, the main control unit 300 may generate the diagnosis switching signal DGS turning on the connection switch 214 for a predetermined period (hereinafter, diagnosis period) before and after the operation of the external electrical device 20.

The main control unit 300 may determine whether the main relays are stuck closed based on the difference between the first detection voltage VS1 and the second detection voltage VS2 that occur during the diagnosis period.

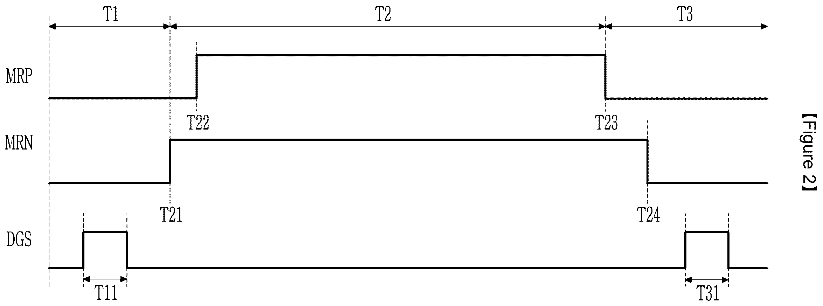

Hereinafter, a stuck closed diagnosis method according to an exemplary embodiment will be described with reference to FIGS. 2 to 6.

FIG. 2 is a diagram illustrating a diagnosis period during which stuck closed diagnosis is performed according to an exemplary embodiment.

FIG. 2 illustrates waveforms of main relay signals MRP and MRN and the diagnostic switching signal DGS. In FIG. 2, the external electrical device 20 is described as an electrical load provided in a vehicle.

A period T1 is a key on period and may be a period from the time the vehicle starts operating to the time the vehicle starts driving (e.g., T21). In a period T11 of the key-on period T1, the diagnostic switching signal DGS is an on level (e.g., high level) and the diagnostic operation may be performed. The key on period is before an electrical connection is provided between the battery device 10 and the external electrical device 20. That is, during the key on period, the positive main relay 201 and the negative main relay 202 are controlled to be in an off state. The diagnosis period may be performed when the control conditions for the positive main relay 201 and negative main relay 202 are turned off.

The main relay signal MRP may be an on level (e.g., high level) during a period T22 to T23, and the main relay signal MRN may be an on level (e.g., high level) during a period T21 to T24. The negative main relay 202 is closed at time T21, and the positive main relay 201 is closed at time T22 after a predetermined period is delayed. The precharge relay 203 may be closed between time T21 and time T22, and the precharge relay 203 may be opened after time T22. The negative main relay 202 is opened at time T24, and the positive main relay 201 is closed at time T23. Power may be supplied from the battery device 10 to the external electrical device 20 during the vehicle driving period T2.

The period T3 is a period after the key off time, and the vehicle ends driving and is in an off state. In the period T31 of the key off period T3, the diagnostic switching signal DGS is an on level and the diagnosis operation may be performed. In the period after the key off time, the electrical connection between the battery device 10 and the external electrical device 20 is blocked. That is, in the key off period, the positive main relay 201 and the negative main relay 202 are controlled to be in an off state.

During the diagnosis periods T11 and T31, the main control unit 300 generates the main relay signal MRP and the main relay signal MRN in the off level, so that when the positive main relay 201 and the negative main relay 202 are in a normal state, in the periods T11 and T31, the positive main relay 201 and negative main relay 202 are in an open state. However, when at least one of the positive main relay 201 and the negative main relay 202 is stuck closed, the first detection voltage VS1 and the second detection voltage VS2 provided to the main control unit 300 may be different from the level in the normal state.

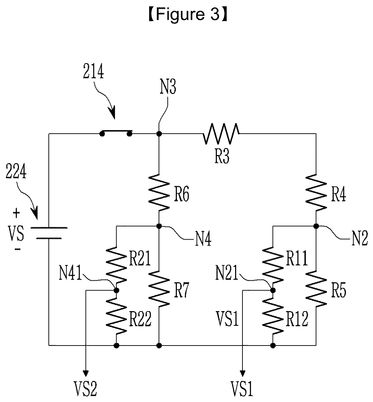

FIG. 3 is an equivalent circuit illustrating the relay diagnostic circuit when the positive main relay and the negative main relay are in a normally opened state.

Hereinafter, the state in which the positive main relay 201 and the negative main relay 202 are normally opened is referred to as a normal state.

Since the connection switch 214 is in an on state during the diagnosis period, the voltage VS of the detection voltage source 224 may be supplied to the node N3. The voltage VS may be resistance-divided by the composite resistance of the four resistors R6 and the resistors R7, R21, and R22 to become the voltage of the node N4, and the voltage of the node N4 may be resistance-divided by the two resistors R21 and R22 to become the second detection voltage VS2. The voltage VS may be resistance-divided by the composite resistance of the resistors R3 and R4 and the composite resistance of the resistors R5, R11, and R12 to become the voltage of the node N2, and the voltage of the node N2 may be resistance-divided by the two resistors R11 and R12 to become the first detection voltage VS1. In the normal state, the first detection voltage VS1 may be expressed as in Equation 1, and the second detection voltage VS2 may be expressed as in Equation 2. In Equations 1 and 2, R3, R4, R5, R6, R7, R11, R12, R21, and R22 may represent resistance values.

$$VS1 = VS* ( (R5// (R11+R12)/ (R3+R4+ (R5// (R11+R12)))* (R12/ (R11+R12)) \qquad \text{[Equation 1]}$$

[Equation 2]

$$VS2 = VS* ( (R7// (R21+R22)/ (R6+ (R7// (R21+R22)))* (R22/ (R21+R22))$$

The resistors R11, R12, R21, and R22 have the same resistance value, the resistors R4 and R6 have the same resistance value, the resistors R5 and R7 have the same resistance value, and the resistance value of the resistor R3 may be very small compared to the resistance values of other resistors. Then, the first detection voltage VS1 and the second detection voltage VS2 may have similar values in a normal state. Therefore, the difference between the first detection voltage VS1 and the second detection voltage VS2 may be a voltage close to zero voltage. The main control unit 300 measures the second detection voltage VS2 and the first detection voltage VS1 during the diagnosis period, and when the difference between the first detection voltage VS1 and the second detection voltage VS2 is within a predetermined normal range, may determine that the positive main relay 201 and the negative main relay 202 are in the normally opened state. The normal range may be set as a range including a predetermined margin based on the zero voltage. For example, the normal range includes the range from a lower bound '-NR[V]' to an upper bound 'NR[V]', where 'NR' may be a positive real number excluding 0.

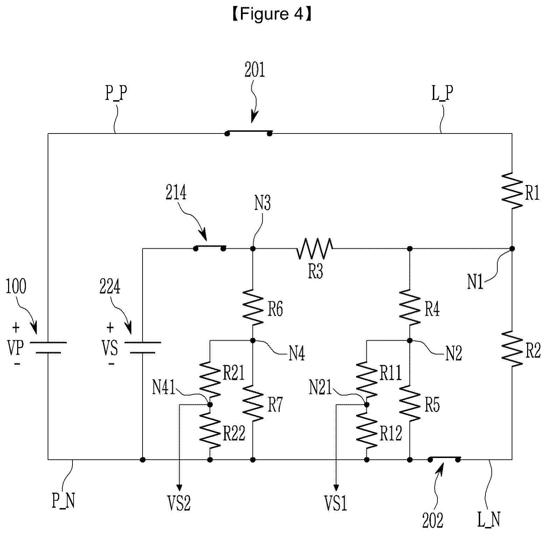

FIG. 4 is an equivalent circuit illustrating a relay diagnostic circuit when the positive and negative main relays are in the stuck closed state.

Hereinafter, the state in which both the positive and negative main relays illustrated in FIG. 4 are stuck closed is referred to as a first stuck closed state.

As illustrated in FIG. 4, compared to FIG. 3 in the normal state, the battery pack 100 operates as a voltage source of the relay diagnostic circuit 204 through the stuck closed positive main relay 201, and the negative electrode of the battery pack 100 and the link negative node L_N are connected through the stuck closed negative main relay 202.

The second detection voltage VS2 may be determined by resistance-dividing the voltage VS provided from the detection voltage source 224 to the node N3 in the same manner as in the normal state. That is, the second detection voltage VS2 may be determined as in Equation 2.

One end of the resistor R1 may be connected to the positive electrode of the battery pack 100, and the other end of the resistor R2 may be connected to the negative electrode of the battery pack 100. Then, the first detection voltage VS1 may be determined by currents provided from each of the detection voltage source 224 and the battery pack 100 to the resistor R12. A multiplication of a third current, which is a sum of a first current flowing through the two resistors R11 and R12 by the detection voltage source 224 and a second current flowing through the two resistors R11 and R12 by the battery pack 100 according to the superposition principle, by the resistance value of the resistor R12 becomes the first detection voltage VS1. In the normal state, the third current is greater than the current flowing through the resistors R11 and R12 by the voltage VS of the detection voltage source 224, so the level of the first detection voltage VS1 in the first stuck closed state is higher than that of the first detection voltage VS1 in the normal state. The main control unit 300 measures the first detection voltage VS1 and the second detection voltage VS2 during the diagnosis period, and when the difference between the first detection voltage VS1 and the second detection voltage VS2 is greater than the upper bound of the normal range, may determine that both the positive main relay 201 and the negative main relay 202 are in the first stuck closed state that is the stuck closed state.

Specifically, in the first stuck closed state, the first detection voltage VS1 may be a sum of a voltage VP_N21 applied to the detection node N21 by resistance-dividing the voltage (hereinafter referred to as the voltage of the battery pack) VP of the battery pack 100 and a voltage VS_N21 applied to the detection node N21 by resistance-dividing the voltage VS of the detection voltage source 224.

In the first stuck closed state, the battery pack voltage VP is resistance-divided and the voltage VP_N1 applied to the node N1 is expressed as in Equation 3. According to the superposition principle, in Equation 3, the detection voltage source 224 is considered a short circuit.

$$VP\_N1 = VP * (R3// (R4+ (R5// (R11+R12))))/ (R1+ (R2// (R3// (R4+ (R5// (R11+R12)))))) \qquad \text{[Equation 3]}$$

In the first stuck closed state, the battery pack voltage VP is resistance-divided, and the voltage VP_N21 applied to the detection node N21 is a voltage obtained by resistance-dividing the voltage VP_N1 of the node N1 in Equation 3 as in Equation 4.

$$VP\_N21 = VP\_N1 * (R5// (R11+R12))/ (R4+ (R5// (R11+R12)))* (R12/ (R11+R12)) \qquad \text{[Equation 4]}$$

In the first stuck closed state, the voltage VS is resistance-divided, and the voltage VS_N1 applied to the node N1 is expressed as in Equation 5. According to the superposition principle, in Equation 5, the battery pack 100 is considered a short circuit.

$$VS\_N1 = VS * ( (R1//R2)// (R4+ (R5// (R11+R12))))/ (R3+ ( (R1//R2)// (R4+ (R5// (R11+R12))))) \qquad \text{[Equation 5]}$$

In the first stuck closed state, the voltage VS is resistance-divided, and the voltage VS_N21 applied to the detection node N21 is a voltage obtained by resistance-dividing the voltage VS_N1 of the node N1 in Equation 5 as in Equation 6.

$$VS\_N21 = VS\_N1 * (R5// (R11+R12))/ (R4+ (R5// (R11+R12)))* (R12/ (R11+R12)) \qquad \text{[Equation 6]}$$

In the first stuck closed state, the first detection voltage VS1 is expressed as in Equation 7 that is the sum of Equation 4 and Equation 6. In Equation 7, V_N1 is the voltage of the node N1 and may be VS_N1+VP_N1.

$$VS1 = V\_N1 * (R5// (R11+R12))/ (R4+ (R5// (R11+R12)))* (R12/ (R11+R12)) \qquad \text{[Equation 7]}$$

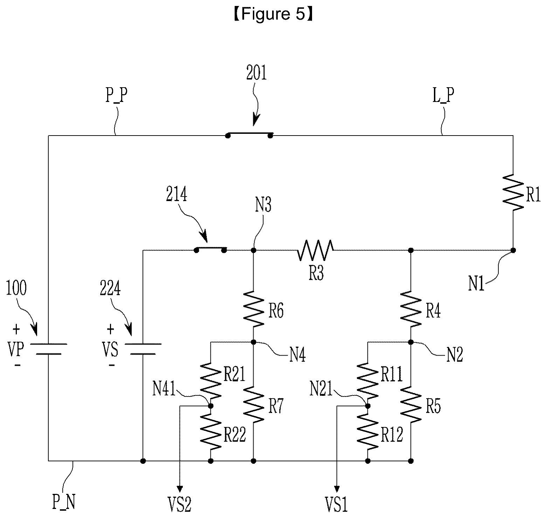

FIG. 5 is an equivalent circuit illustrating the relay diagnostic circuit when the positive main relay is in the stuck closed state.

Hereinafter, the state in which the positive main relay illustrated in FIG. 5 is stuck closed and the negative main relay is opened is referred to as a second stuck closed state.

As illustrated in FIG. 5, compared to FIG. 3 in the normal state, the battery pack 100 may operate as a voltage source for the relay diagnostic circuit 204 through the stuck closed positive main relay 201.

The second detection voltage VS2 may be determined by resistance-dividing the voltage VS provided from the detection voltage source 224 to the node N3 in the same manner as in the normal state. That is, the second detection voltage VS2 may be determined as in Equation 2.

One end of the resistor R1 may be connected to the positive electrode of the battery pack 100. Compared to FIG. 4, in the second stuck closed state, the resistor R2 is not connected to the negative electrode of the battery pack 100 and does not participate in the resistance division.

Even in the second stuck closed state, the first detection voltage VS1 may be determined by currents provided from each of the detection voltage source 224 and the battery pack 100 to the resistor R12. A multiplication of a sixth current, which is a sum of a fourth current flowing through the two resistors R11 and R12 by the detection voltage source 224 and a fifth current flowing through the two resistors R11 and R12 by the battery pack 100 according to the superposition principle, by the resistance value of the resistor R12 becomes the first detection voltage VS1. In the normal state, the sixth current is greater than the current flowing through the resistors R11 and R12 by the voltage VS of the detection voltage source 224, so the level of the first detection voltage VS1 in the second stuck closed state is higher than that of the first detection voltage VS1 in the normal state. The main control unit 300 may measure the first detection voltage VS1 and the second detection voltage VS2 during the diagnosis period, and when the difference between the first detection voltage VS1 and the second detection voltage VS2 is greater than the upper bound of the normal range, may determine that the positive main relay 201 is in the second stuck closed state that is the stuck closed state.

Specifically, in the second stuck closed state, the first detection voltage VS1 may be a sum of the voltage VP_N21 applied to the detection node N21 by resistance-dividing the battery pack voltage VP and the voltage VS_N21 applied to the detection node N21 by resistance-dividing the voltage VS of the detection voltage source 224.

In the second stuck closed state, the battery pack voltage VP is resistance-divided and the voltage VP_N1 applied to the node N1 is expressed as in Equation 8. According to the superposition principle, in Equation 8, the detection voltage source 224 is considered a short circuit.

$$VP\_N1 = VP* (R3// (R4+ (R5// (R11+R12))))/ (R1+ ( (R3// (R4+ (R5// (R11+R12)))) \qquad \text{[Equation 8]}$$

In the second stuck closed state, the battery pack voltage VP is resistance-divided, and the voltage VP_N21 applied to the detection node N21 is a voltage obtained by resistance-dividing the voltage VP_N1 of the node N1 in Equation 8 as in Equation 4.

In the second stuck closed state, the voltage VS is resistance-divided, and the voltage VS_N1 applied to the node N1 is expressed as in Equation 9. According to the superposition principle, in Equation 9, the battery pack 100 is considered a short circuit.

$$VS\_N1=VS* (R1// (R4+ (R5// (R11+R12))))/ (R3+ (R1// (R4+ (R5// (R11+R12))))) \qquad \text{[Equation 9]}$$

In the second stuck closed state, the voltage VS is resistance-divided, and the voltage VS_N21 applied to the detection node N21 is a voltage obtained by resistance-dividing the voltage VS_N1 of the node N1 in Equation 9 as in Equation 6.

In the second stuck closed state, the first sense voltage VS1 is expressed as in Equation 7.

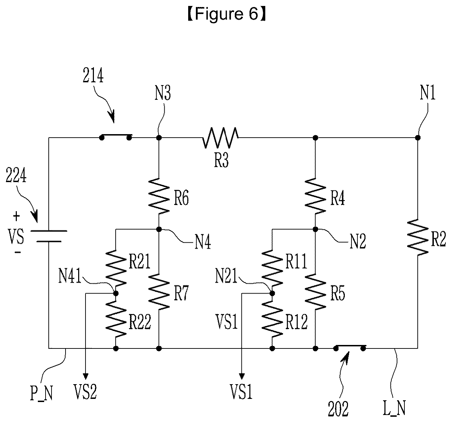

FIG. 6 is an equivalent circuit illustrating the relay diagnostic circuit when the negative main relay is in the stuck closed state.

Hereinafter, the state in which the negative main relay 202 illustrated in FIG. 6 is stuck closed and the positive main relay 201 is opened is referred to as a third stuck closed state.

As illustrated in FIG. 5, compared to FIG. 3 in the normal state, the battery pack 100 may operate as a voltage source for the relay diagnostic circuit 204 through the stuck closed positive main relay 201.

The second detection voltage VS2 may be determined by resistance-dividing the voltage VS provided from the detection voltage source 224 to the node N3 in the same manner as in the normal state. That is, the second detection voltage VS2 may be determined as in Equation 2.

In the third stuck closed state, the resistor R2 may be connected to the negative electrode of the detection voltage source 224 through the stuck closed negative main relay 202, and participate in the resistance division of the voltage VS.

Specifically, in the third stuck closed state, the voltage VS is resistance-divided, and the voltage VS_N1 applied to the node N1 is expressed as in Equation 10.

$$VS\_N1=VS* (R2// (R4+ (R5// (R11+R12))))/ (R3+ (R2// (R4+ (R5// (R11+R12))))) \qquad \text{[Equation 10]}$$

In the third stuck closed state, the voltage VS is resistance-divided, and the voltage VS_N21 applied to the detection node N21 is a voltage obtained by resistance-dividing the voltage VS_N1 of the node N1 in Equation 10 as in Equation 6.

Compared to the normal state of FIG. 3, in the circuit of FIG. 6, the resistor R2 is further connected in parallel to the node N1. Then, the composite resistance seen from the node N1 decreases in the third stuck closed state compared to the normal state. Accordingly, the voltage applied to the node N1 decreases in the third stuck closed state compared to the normal state, and the first detection voltage VS1 also decreases.

The main control unit 300 may measure the first detection voltage VS1 and the second detection voltage VS2 during the diagnosis period, and when the difference between the first detection voltage VS1 and the second detection voltage VS2 is less than the lower bound of the normal range, may determine that the negative main relay 202 is in the third stuck closed state that is the stuck closed state.

Using the relay diagnostic circuit according to the present disclosure, there is no need to add a large and complex circuit such as a comparator to perform the stuck closed diagnosis for the main relays. As may be seen from the exemplary embodiment described above, the stuck closed diagnosis may be provided to the main relays using only the resistance division circuit composed of the resistance elements.

Although embodiments of the present disclosure have been described in detail hereinabove, the scope of the present disclosure is not limited thereto, but may include several modifications and alterations made by those skilled in the art using a basic concept of the present disclosure as defined in the claims.

## Claims

1. A relay diagnostic circuit for performing diagnosis on a positive main relay and a negative main relay that control a connection between a battery pack and an external electrical device, the relay diagnostic circuit comprising:

   a detection voltage source;
   a first resistor and a second resistor connected in series between a first connection terminal and a second connection terminal;
   a third resistor and a fourth resistor connected in series between a first node to which the first resistor and the second resistor are connected and a negative electrode of the battery pack;
   a fifth resistor and a sixth resistor connected in series between a second node to which the third resistor and the fourth resistor are connected and the negative electrode of the battery pack;
   a connection switch connected between the detection voltage source and a third node;
   a seventh resistor connected between the third node and the first node;
   an eighth resistor and a ninth resistor connected in series between the third node and the negative electrode of the battery pack; and
   a tenth resistor and an eleventh resistor connected in series between a fourth node to which the eighth resistor and the ninth resistor are connected and the negative electrode of the battery pack.

2. The relay diagnostic circuit of claim 1, wherein:
   the connection switch is turned on during a predetermined diagnosis period, and a first detection voltage that is a voltage of a first detection node to which the fifth resistor and the sixth resistor are connected and a second detection voltage that is a voltage of a second detection node to which the tenth resistor and the eleventh resistor are connected are provided.

3. The relay diagnostic circuit of claim 2, wherein:

   when the positive main relay and the negative main relay are stuck closed,
   during the diagnosis period, a positive electrode of the battery pack is connected to the first resistor, and the negative electrode of the battery pack is connected to the second resistor,
   so that a voltage applied to the first detection node by resistance-dividing the voltage of the battery pack by the first resistor, the second resistor, the third resistor, the fourth resistor, the fifth resistor, and the sixth resistor and a voltage applied to the second detection node by resistance-dividing the voltage of the detection voltage source by the seventh resistor, the second resistor, the third resistor, the fourth resistor, the fifth resistor, and the sixth resistor are added to determine the first detection voltage.

4. The relay diagnostic circuit of claim 2, wherein:

   when the positive main relay is stuck closed,
   during the diagnosis period, a positive electrode of the battery pack is connected to the first resistor,

so that a voltage applied to the first detection node by resistance-dividing the voltage of the battery pack by the first resistor, the third resistor, the fourth resistor, the fifth resistor, and the sixth resistor and a voltage applied to the second detection node by resistance-dividing the voltage of the detection voltage source by the seventh resistor, the third resistor, the fourth resistor, the fifth resistor, and the sixth resistor are added to determine the first detection voltage.

5. The relay diagnostic circuit of claim 2, wherein:

when the negative main relay is stuck closed,
during the diagnosis period, the negative electrode of the battery pack is connected to the second resistor, so that the first detection voltage is determined by resistance-dividing the voltage of the detection voltage source by the seventh resistor, the second resistor, the third resistor, the fourth resistor, the fifth resistor, and the sixth resistor.

6. The relay diagnostic circuit of claim 2, wherein:

when the positive main relay and the negative main relay are in a normal state,
during the diagnosis period, the first detection voltage is determined by resistance-dividing the voltage of the detection voltage source by the seventh resistor, the third resistor, the fourth resistor, the fifth resistor, and the sixth resistor, and the second detection voltage is determined by resistance-dividing the voltage of the detection voltage source by the eighth resistor, the ninth resistor, the tenth resistor, and the eleventh resistor.

7. A battery device, comprising:

a battery pack; and
a battery disconnect unit including a positive main relay connected between a positive electrode of the battery pack and a first connection terminal, and a negative main relay connected between a negative electrode of the battery pack and a second connection terminal,
wherein the battery disconnect unit includes:

a first resistor and a second resistor connected in series between the first connection terminal and the second connection terminal;
a third resistor and a fourth resistor connected in series between a first node to which the first resistor and the second resistor are connected and a negative electrode of the battery pack; and
a fifth resistor and a sixth resistor connected in series between a second node to which the third resistor and the fourth resistor are connected and the negative electrode of the battery pack, and
the battery device measures a first detection voltage that is a voltage of a first detection node to which the fifth and sixth resistors are connected during a predetermined diagnostic period during which the battery pack is not connected to an external electrical device, and performs a stuck closed diagnosis for the positive main relay and the negative main relay according to the first detection voltage.

8. The battery device of claim 7, wherein:
the battery disconnect unit further includes:

a detection voltage source;
a connection switch connected between the detection voltage source and a third node and turned on during the diagnosis period;
a seventh resistor connected between the third node and the first node;
an eighth resistor and a ninth resistor connected in series between the third node and the negative electrode of the battery pack; and
a tenth resistor and an eleventh resistor connected in series between a fourth node to which the eighth resistor and the ninth resistor are connected and the negative electrode of the battery pack, and
the battery device measures a second detection voltage that is a voltage of a second detection node to which the tenth resistor and the eleventh resistor are connected during the diagnosis period, and performs the stuck closed diagnosis for the positive main relay and the negative main relay according to a difference between the first detection voltage and the second detection voltage.

9. The battery device of claim 8, further comprising:

a main control unit turning off the positive main relay and the negative main relay and turning on the connection switch during the diagnosis period, measuring the first detection voltage and the second detection voltage, and performing the stuck closed diagnosis for the positive main relay and the negative main relay according to a first voltage that is the difference between the first detection voltage and the second detection voltage.

10. The battery device of claim 9, wherein:

the main control unit
determines that the positive main relay and the negative main relay are in a normal state when the first voltage falls within a predetermined normal range, and
determines that at least one of the positive main relay and the negative main relay is stuck closed when the first voltage is outside the normal range.

11. The battery device of claim 10, wherein:

the predetermined normal range
is determined according to a difference between the first detection voltage determined by resistance-dividing the voltage of the detection voltage source by the seventh resistor, the third resistor, the fourth resistor, the fifth resistor, and the sixth resistor, and the second detection voltage determined by resistance-dividing the voltage of the detection voltage source by the eighth resistor, the ninth resistor, the tenth resistor, and the eleventh resistor.

12. The battery device of claim 10, wherein:

the main control unit
determines that both the positive main relay and the negative main relay are stuck closed or that the positive main relay is stuck closed when the first voltage is higher than an upper limit of the normal range.

13. The battery device of claim 10, wherein:

the main control unit
determines that the negative main relay is stuck closed when the first voltage is lower than a lower bound of the normal range.

14. The battery device of claim 8, wherein:

when the positive main relay and the negative main relay are stuck closed,
during the diagnosis period, the positive electrode of the battery pack is connected to the first resistor, and the negative electrode of the battery pack is connected to the second resistor,
so that the voltage applied to the first detection node by resistance-dividing the voltage of the battery pack by the first resistor, the second resistor, the third resistor, the fourth resistor, the fifth resistor, and the sixth resistor and the voltage applied to the second detection node by resistance-dividing the voltage of the detection voltage source by the seventh resistor, the second resistor, the third resistor, the fourth resistor, the fifth resistor, and the sixth resistor are added to determine the first detection voltage.

15. The battery device of claim 8, wherein:

when the positive main relay is stuck closed,
during the diagnosis period, the positive electrode of the battery pack is connected to the first resistor,
so that the voltage applied to the first detection node by resistance-dividing the voltage of the battery pack by the first resistor, the third resistor, the fourth resistor, the fifth resistor, and the sixth resistor and the voltage applied to the second detection node by resistance-dividing the voltage of the detection voltage source by the seventh resistor, the third resistor, the fourth resistor, the fifth resistor, and the sixth resistor are added to determine the first detection voltage.

16. The battery device of claim 8, wherein:

when the negative main relay is stuck closed,
during the diagnosis period, the negative electrode of the battery pack is connected to the second resistor,

so that the first detection voltage is determined by resistance-dividing the voltage of the detection voltage source by the seventh resistor, the second resistor, the third resistor, the fourth resistor, the fifth resistor, and the sixth resistor.

17. The battery device of claim 8, wherein:

when the positive and negative main relay and the negative main relay are in a normal state, during the diagnosis period, the first detection voltage is determined by resistance-dividing the voltage of the detection voltage source by the seventh resistor, the third resistor, the fourth resistor, the fifth resistor, and the sixth resistor, and the second detection voltage is determined by resistance-dividing the voltage of the detection voltage source by the eighth resistor, the ninth resistor, the tenth resistor, and the eleventh resistor.

【Figure 1】

【Figure 2】

【Figure 3】

【Figure 4】

【Figure 5】

【Figure 6】

## INTERNATIONAL SEARCH REPORT

| International application No. |
|---|
| **PCT/KR2024/005863** |

### A. CLASSIFICATION OF SUBJECT MATTER

**G01R 31/327**(2006.01)i; **G01R 31/52**(2020.01)i; **G01R 31/56**(2020.01)i; **G01R 27/02**(2006.01)i; **G01R 19/00**(2006.01)i; **G01R 19/10**(2006.01)i; **G01R 19/165**(2006.01)i

According to International Patent Classification (IPC) or to both national classification and IPC

### B. FIELDS SEARCHED

Minimum documentation searched (classification system followed by classification symbols)

G01R 31/327(2006.01); G01R 19/165(2006.01); G01R 31/36(2006.01); G01R 31/66(2020.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 팩(battery pack), 메인 릴레이(main relay), 감지 전압원(detect voltage), 저항 (resistance), 스위치(switch)

### C. DOCUMENTS CONSIDERED TO BE RELEVANT

| Category* | Citation of document, with indication, where appropriate, of the relevant passages | Relevant to claim No. |
|---|---|---|
| A | KR 10-2022-0049950 A (LG ENERGY SOLUTION, LTD.) 22 April 2022 (2022-04-22)<br>See paragraphs [0037]-[0072] and figure 1. | 1-17 |
| A | KR 10-2021-0068895 A (LG ENERGY SOLUTION, LTD.) 10 June 2021 (2021-06-10)<br>See paragraphs [0078]-[0101] and figures 4-5. | 1-17 |
| A | KR 10-2019-0051555 A (LG CHEM, LTD.) 15 May 2019 (2019-05-15)<br>See paragraph [0031] and figures 1-3. | 1-17 |
| A | US 2007-0139005 A1 (OSAWA, Ken) 21 June 2007 (2007-06-21)<br>See paragraphs [0035]-[0044] and figure 3. | 1-17 |
| A | KR 10-2052956 B1 (LG INNOTEK CO., LTD.) 09 December 2019 (2019-12-09)<br>See paragraphs [0020]-[0027] and figure 1. | 1-17 |

☐ Further documents are listed in the continuation of Box C.  ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **06 August 2024** | **07 August 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/005863**

| Patent document cited in search report | | | Publication date (day/month/year) | Patent family member(s) | | | Publication date (day/month/year) |
|---|---|---|---|---|---|---|---|
| KR | 10-2022-0049950 | A | 22 April 2022 | CN | 115136016 | A | 30 September 2022 |
| | | | | EP | 4099034 | A1 | 07 December 2022 |
| | | | | JP | 2023-511169 | A | 16 March 2023 |
| | | | | JP | 7416488 | B2 | 17 January 2024 |
| | | | | US | 11774499 | B2 | 03 October 2023 |
| | | | | US | 2023-0099667 | A1 | 30 March 2023 |
| | | | | WO | 2022-080709 | A1 | 21 April 2022 |
| KR | 10-2021-0068895 | A | 10 June 2021 | None | | | |
| KR | 10-2019-0051555 | A | 15 May 2019 | CN | 110662975 | A | 07 January 2020 |
| | | | | CN | 110662975 | B | 03 May 2022 |
| | | | | EP | 3620803 | A1 | 11 March 2020 |
| | | | | EP | 3620803 | B1 | 17 May 2023 |
| | | | | JP | 2020-521423 | A | 16 July 2020 |
| | | | | JP | 6980976 | B2 | 15 December 2021 |
| | | | | KR | 10-2291762 | B1 | 03 September 2021 |
| | | | | US | 11204386 | B2 | 21 December 2021 |
| | | | | US | 2020-0142002 | A1 | 07 May 2020 |
| | | | | WO | 2019-093667 | A1 | 16 May 2019 |
| US | 2007-0139005 | A1 | 21 June 2007 | JP | 2007-165253 | A | 28 June 2007 |
| | | | | JP | 4510753 | B2 | 28 July 2010 |
| | | | | US | 7608940 | B2 | 27 October 2009 |
| KR | 10-2052956 | B1 | 09 December 2019 | KR | 10-2014-0136844 | A | 01 December 2014 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230065485